# EUROPEAN PATENT APPLICATION

(11) **EP 4 656 324 A1**
(43) Date of publication of application: **03.12.2025**
(21) Application number: 24779742.6
(22) Date of filing: 19.03.2024
(51) Int. Cl.: B23K 26/046, B23K 26/364, H01L 21/301

(54) **LASER PROCESSING DEVICE**

(30) Priority: 31.03.2023 JP 2023058060
(71) Applicant: Tokyo Seimitsu Co., Ltd., Hachioji-shi, Tokyo 192-8515 (JP)
(72) Inventor: HAYASHI Hirokazu, Hachioji-shi, Tokyo 192-8515 (JP)
(74) Representative: Gill Jennings & Every LLP
(86) International application number: PCT/JP2024/010749
(87) International publication number: WO 2024/203617

(57) **Abstract**

A laser machining device for machining a workpiece by radiating a laser beam from a laser machining head to the workpiece to which a machining feed operation is relatively applied. The laser machining head includes a first machining unit configured to machine two grooves by radiating a pair of laser beams to the workpiece, a second machining unit configured to machine an area between the two grooves by radiating a second laser beam between the two grooves machined by the first machining unit, and a first focus adjustment unit configured to adjust a relative positional relationship between a focus of the first laser beam and a focus of the second laser beam in an optical axis direction by relatively moving a focal position of the second laser beam with respect to a focal position of the first laser beam in the optical axis direction.

## Description

### TECHNICAL FIELD

The present invention relates to a laser machining device, and more particularly to a laser machining device for machining a groove in a workpiece. Priority is claimed on Japanese Patent Application No. 2023-058060, filed March 31, 2023, the content of which is incorporated herein by reference.

### BACKGROUND ART

When chips are created from semiconductor wafers with a low-k (low dielectric constant) film as an interlayer insulating film using a normal blade dicer, there is a problem because delamination occurs.

Patent Document 1 proposes a method of suppressing delamination by machining two grooves along streets with laser beams and cutting an area between the two grooves with a blade as a method of machining a wafer having a low-k film.

Moreover, Patent Document 2 proposes a method of machining two grooves along streets with laser beams and cutting an area between the two grooves with a laser beam.

### Citation List

### Patent Document

Patent Document 1: Japanese Unexamined Patent Application, First Publication No. 2005-142398
Patent Document 2: Japanese Unexamined Patent Application, First Publication No. 2009-182019

### SUMMARY OF INVENTION

### Technical Problem

Incidentally, in the machining method described in Patent Document 2, a process of machining the two grooves and a process of machining an area between the two grooves are performed using separate machining means provided within a single device. Each machining means includes a separate drive mechanism or the like and position adjustment and the like are provided for machining. However, if a plurality of machining means or a plurality of machining units each having a separate drive mechanism or the like are provided within a single device, there is a disadvantage because a configuration of the device becomes complex and large. In this regard, a process of mounting a plurality of machining units on a single laser machining head and sharing the drive mechanism or the like between the machining units is also conceivable. However, if a plurality of machining units are mounted on a single laser machining head and the drive mechanism or the like is shared, because a mechanism for focus adjustment is also shared between the machining units, there is a disadvantage because the focal position of each machining unit cannot be adjusted separately.

The present invention has been made in consideration of the above circumstances and an objective of the present invention is to provide a laser machining device capable of separately adjusting a focal position between machining units.

### Solution to Problem

According to a first aspect for solving the above-described problems, there is provided a laser machining device for machining a workpiece by radiating a laser beam from a laser machining head to the workpiece to which a machining feed operation is relatively applied, in which the laser machining head includes a first machining unit configured to machine two grooves by radiating a pair of laser beams to the workpiece; a second machining unit configured to machine an area between the two grooves by radiating a second laser beam between the two grooves machined by the first machining unit; and a first focus adjustment unit configured to adjust a relative positional relationship between a focus of the first laser beam and a focus of the second laser beam in an optical axis direction by relatively moving a focal position of the second laser beam with respect to a focal position of the first laser beam in the optical axis direction.

According to a second aspect, in the laser machining device according to the first aspect, the laser machining head further includes a second focus adjustment unit configured to adjust focal positions of the first laser beam and the second laser beam in the optical axis direction while maintaining a relative positional relationship between the focus of the first laser beam and the focus of the second laser beam in the optical axis direction.

According to a third aspect, in the laser machining device according to the first or second aspect, the first focus adjustment unit relatively moves a focal position of the second laser beam with respect to a focal position of the first laser beam in the optical axis direction by adjusting a position of a condenser lens in at least one of the first machining unit and the second machining unit in the optical axis direction.

According to a fourth aspect, in the laser machining device according to the third aspect, the first focus adjustment unit adjusts a position of the condenser lens in the optical axis direction by moving the condenser lens in the optical axis direction with an actuator.

According to a fifth aspect, in the laser machining device according to any one of the first to fourth aspects, a plurality of second machining units are provided, and the plurality of second machining units and the first machining unit are arranged in a machining feed direction.

According to a sixth aspect, in the laser machining device according to the fifth aspect, the first machining unit is arranged between the second machining units.

According to a seventh aspect, in the laser machining device according to the second aspect, the laser machining head further includes a control unit configured to receive settings of focal positions of the first laser beam and the second laser beam and control the first focus adjustment unit and the second focus adjustment unit so that the focuses of the first laser beam and the second laser beam are positioned at the positions that have been received.

According to an eighth aspect, in the laser machining device according to the seventh aspect, the control unit receives a designation of an amount of defocus and receives the settings of the focal positions of the first laser beam and the second laser beam.

### Advantageous Effects of Invention

According to the present invention, it is possible to separately adjust a focal position between machining units.

### BRIEF DESCRIPTION OF DRAWINGS

[FIG. 1] A plan view showing an example of a machining target.
[FIG. 2] A diagram showing an overview of a groove machining process.
[FIG. 3] A schematic diagram showing an embodiment of a laser machining device.
[FIG. 4] A schematic diagram showing an example of a hardware configuration of a control device.
[FIG. 5] A schematic diagram showing an embodiment of a laser machining head.
[FIG. 6] A conceptual diagram of irradiation of a first laser beam from a first condenser lens.
[FIG. 7] A schematic diagram showing an example of a configuration of an optical path switching unit.
[FIG. 8] A conceptual diagram of irradiation of a second laser beam from a second condenser lens.
[FIG. 9] A flowchart showing a flow of a machining process of the laser machining device.
[FIG. 10] A flowchart showing a procedure of a focus adjustment process.

### DESCRIPTION OF EMBODIMENTS

Hereinafter, preferred embodiments of the present invention will be described with reference to the accompanying drawings.

Here, an example in which the present invention is applied to a device for removing a wiring layer including a low-k film from streets before dicing a semiconductor wafer that uses a low-k film as an interlayer insulating film will be described. The wafer is an example of a workpiece.

The low-k film serving as the interlayer insulating film is made of a low-k material (a low dielectric constant material). Examples of the low-k material include inorganic materials such as SiO₂, SiOC, and SiLK, organic materials, which are polymers such as polyimide, parylene, and polytetrafluoroethylene, a porous silica material such as methyl-containing polysiloxane, and the like.

### [Overview of laser machining]

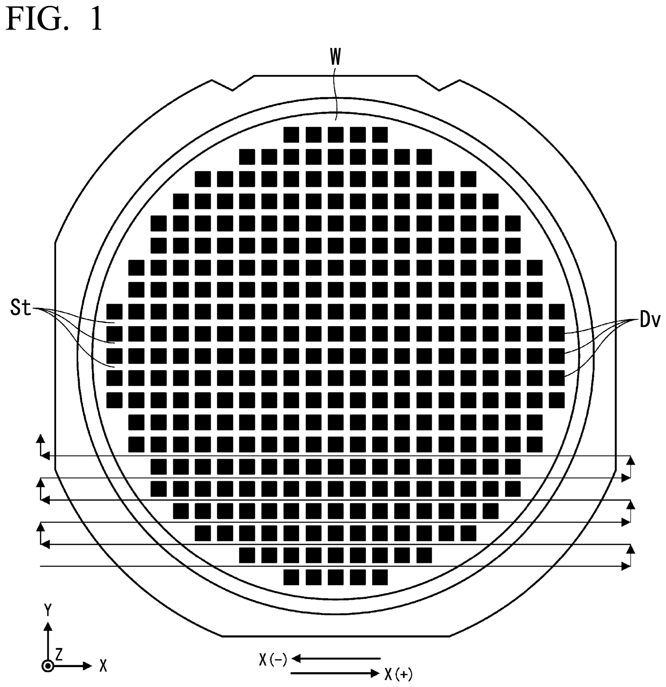

FIG. 1 is a plan view showing an example of a machining target.

As shown in FIG. 1, a semiconductor wafer W that is the machining target has devices Dv formed in lattice-like regions partitioned by a plurality of streets St, which are scheduled division lines. In a wafer W using a low-k film as an interlayer insulating film, the low-k film is positioned across the streets St between adjacent devices Dv. A predetermined groove is ablated for each street St with a laser beam and the wiring layer including the low-k film is removed from the streets St.

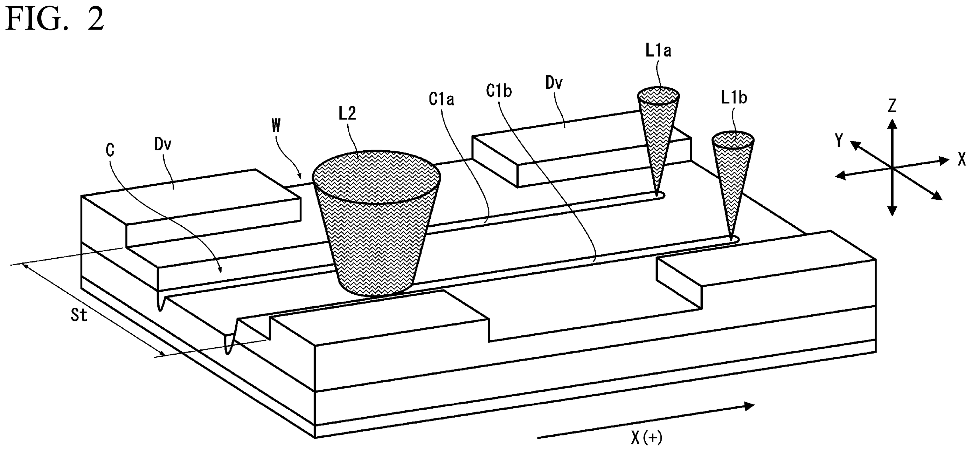

FIG. 2 is a diagram showing an overview of the groove machining.

As shown in FIG. 2, a predetermined groove C is machined along the street St and the wiring layer including the low-k film is removed from the street St. At this time, the groove C is machined in a state in which the process is divided into a machining process of cutting edges on both sides of the groove C and a machining process for cutting the inside the groove C, i.e., a hollowing process. Hereinafter, the machining process for cutting the edges on both sides of the groove C is referred to as an "edge cutting process" and the machining process for cutting the inside of the groove C is referred to as a "hollowing process."

The edge cutting process is performed by radiating a pair of laser beams L1a and L1b along the street St and machining two grooves C1a and C1b parallel to each other along the street St.

The hollowing process is performed by radiating a laser beam L2 having a predetermined width between the two grooves C1a and C1b formed by the edge cutting process. This laser beam L2 is configured as a laser beam capable of machining a groove having a width corresponding to spacing between the two grooves C1a and C1b.

By combining the edge cutting process and the hollowing process, the groove C having a predetermined width and depth is finally formed along the street St.

If the groove C is machined using a laser beam of an output that can remove the low-k film all at once, there is a risk that delamination will occur. However, it is possible to suppress the occurrence of delamination in a machining process divided into the edge cutting process and the hollowing process as described above.

Hereinafter, the pair of laser beams L1a and L1b used in the edge cutting process will be referred to as "first laser beams L1a and L1b," and a laser beam L2 used in the hollowing process will be referred to as a "second laser beam L2," to distinguish between the two. Moreover, the two grooves C1a and C1b machined in the edge cutting process will be referred to as "edge cutting grooves C1a and C1b," and the groove C machined by the edge cutting process and the hollowing process will be referred to as a "wiring layer removal groove C," to distinguish between the two.

### [Laser machining device]

### [Device configuration]

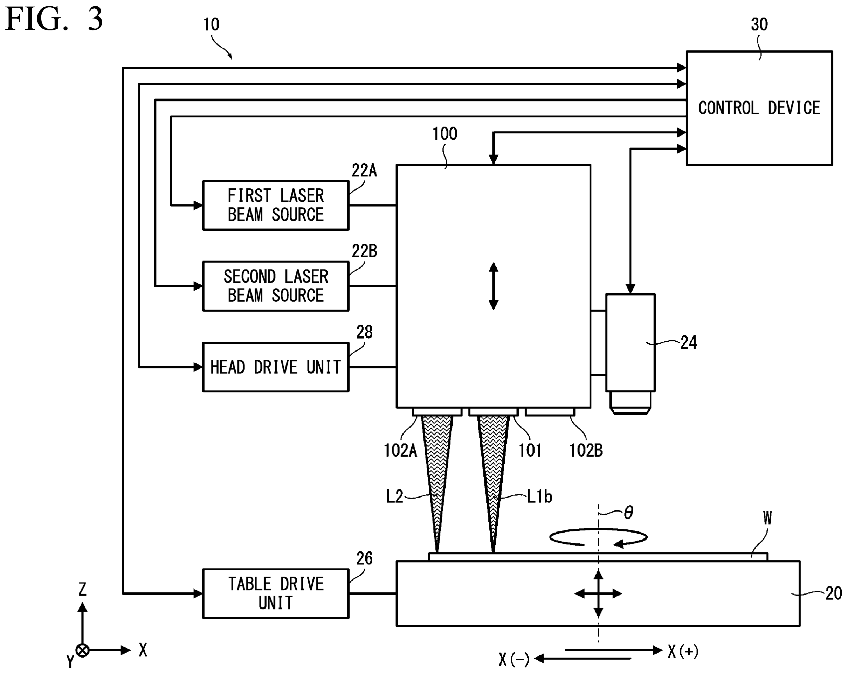

FIG. 3 is a schematic diagram showing an embodiment of a laser machining device. In FIG. 3, X, Y, and Z are three axes that are perpendicular to one another. In the present embodiment, it is assumed that a plane including the X and Y axes is a horizontal plane and X and Y directions are horizontal directions. Moreover, it is assumed that a Z direction is a vertical direction (an up-down direction).

As shown in FIG. 3, the laser machining device 10 of the present embodiment includes a table 20, a first laser beam source 22A, a second laser beam source 22B, a laser machining head 100, a microscope 24, a table drive unit 26, a head drive unit 28, and a control device 30.

The table 20 holds a wafer W. Moreover, the table 20 is driven by the table drive unit 26 under the control of the control device 30 and moves in the X and Y directions. The X direction is a direction of a machining feed operation (which is a feed operation in a direction in which the groove is machined). The street St to be machined is set parallel to the X direction. Moreover, under the control of the control device 30, the table 20 is driven by the table drive unit 26 to rotate around a θ axis. The θ axis passes through the center of the table 20 and is parallel to the Z axis.

The first laser beam source 22A supplies a laser beam LA for the edge cutting process to the laser machining head 100. This laser beam LA is a pulsed laser beam having conditions suitable for the edge cutting process, for example, such as a wavelength, a pulse width, and a repetition frequency.

The second laser beam source 22B supplies a laser beam LB for the hollowing process to the laser machining head 100. This laser beam LB is a pulsed laser beam having conditions suitable for the hollowing process, for example, such as a wavelength, a pulse width, and a repetition frequency.

The laser machining head 100 has a laser optical system and emits the pair of first laser beams L1a and L1b for the edge cutting process and the second laser beam L2 for the hollowing process toward the wafer W on the table 20. The laser beams L1a, L1b, and L2 are emitted vertically downward toward the wafer W on the table 20.

The laser machining head 100 has three emission ports. One emission port is a first emission port 101 that emits the pair of first laser beams L1a and L1b for the edge cutting process. The remaining two emission ports are a (2-1)^{th} emission port 102A and a (2-2)^{th} emission port 102B that emit the second laser beam L2 for the hollowing process.

The three emission ports, i.e., the first emission port 101, the (2-1)^{th} emission port 102A, and the (2-2)^{th} emission port 102B, are aligned and arranged in a row in the machining feed direction (the X direction) of the wafer W. Moreover, the first emission port 101 is arranged between the (2-1)^{th} emission port 102A and the (2-2)^{th} emission port 102B. That is, the (2-1)^{th} emission port 102A and the (2-2)^{th} emission port 102B, which are the emission ports of the laser beam for the hollowing process, are arranged on both sides of the first emission port 101, which is the emission port of the laser beam for the edge cutting process.

The second laser beam L2 for the hollowing process is switched between the (2-1)^{th} emission port 102A and the (2-2)^{th} emission port 102B, which are the emission ports, in accordance with the machining feed direction. Specifically, in FIG. 3, when a machining feed operation is performed in the X (-) direction (the right direction in FIG. 3), the second laser beam L2 is emitted from the (2-1)^{th} emission port 102A. In this case, a machining progress direction becomes the X (+) direction (the left direction in FIG. 3). On the other hand, when a machining feed operation is performed in the X (+) direction (the left direction in FIG. 3), the second laser beam L2 is emitted from the (2-2)^{th} emission port 102B. In this case, the machining progress direction becomes the X (-) direction (the right direction in FIG. 3). That is, the second laser beam L2 is emitted from an emission port positioned on the upstream side of the first emission port 101 in the machining feed direction, in other words, from an emission port positioned on the downstream side of the first emission port 101 in the machining progress direction.

The laser machining head 100 is driven by the head drive unit 28 under the control of the control device 30 and moves in the Z direction.

Details of the laser machining head 100 including the laser optical system will be described below.

The microscope 24 photographs the wafer W held on the table 20. The microscope 24 is fixed to the laser machining head 100 and moves together with the laser machining head 100. An image captured by the microscope 24 is output to the control device 30. The control device 30 performs alignment, kerf check, and the like on the basis of the image captured by the microscope 24.

The table drive unit 26 includes a guide mechanism configured to guide the table 20 in the X direction, a guide mechanism configured to guide the table 20 in the Y direction, bearings configured to rotatably support the table 20, and the like as guide mechanisms. Moreover, the table drive unit 26 includes a motor configured to drive the table 20 in the X direction, a motor configured to drive the table 20 in the Y direction, and a motor configured to rotate the table 20 as actuators. Moreover, the table drive unit 26 includes a sensor configured to detect a position of the table 20 in the X direction, a sensor configured to detect a position of the table 20 in the Y direction, and a sensor configured to detect a rotational position of the table 20 as sensors.

The head drive unit 28 includes a guide mechanism configured to guide the laser machining head 100 in the Z direction, a motor configured to drive the laser machining head 100 in the Z direction, a sensor configured to detect the position of the laser machining head 100 in the Z direction, and the like.

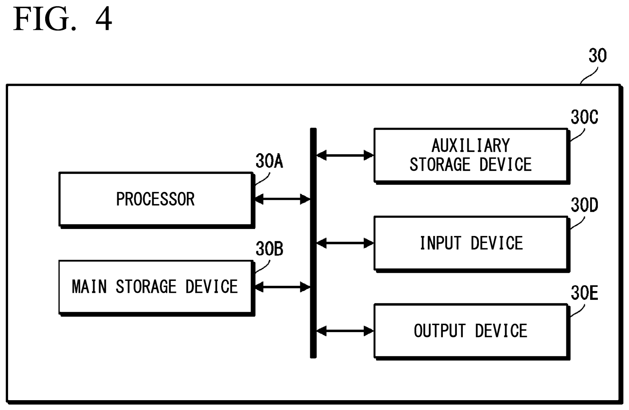

FIG. 4 is a schematic diagram showing an example of a hardware configuration of the control device.

The control device 30 includes a processor 30A, a main storage device 30B, an auxiliary storage device 30C, an input device 30D, an output device 30E, and the like. That is, the control device 30 is configured as a computer, and functions as the control device 30 when the computer executes a predetermined program. The processor 30A is configured as, for example, a central processing unit (CPU). The main storage device 30B is configured as, for example, a random-access memory (RAM). The auxiliary storage device 30C is configured as, for example, a hard disk drive (HDD), a solid-state drive (SSD), and the like. The input device 30D includes operation buttons, a keyboard, a touch panel, or the like. The output device 30E is configured as, for example, a display (a display device). The input device 30D and the output device 30E can also be configured as a touch panel display.

The control device 30 generally controls operations of the first laser beam source 22A, the second laser beam source 22B, the laser machining head 100, the microscope 24, the table drive unit 26, the head drive unit 28, and the like. The control device 30 is an example of a control unit.

### [Laser machining head]

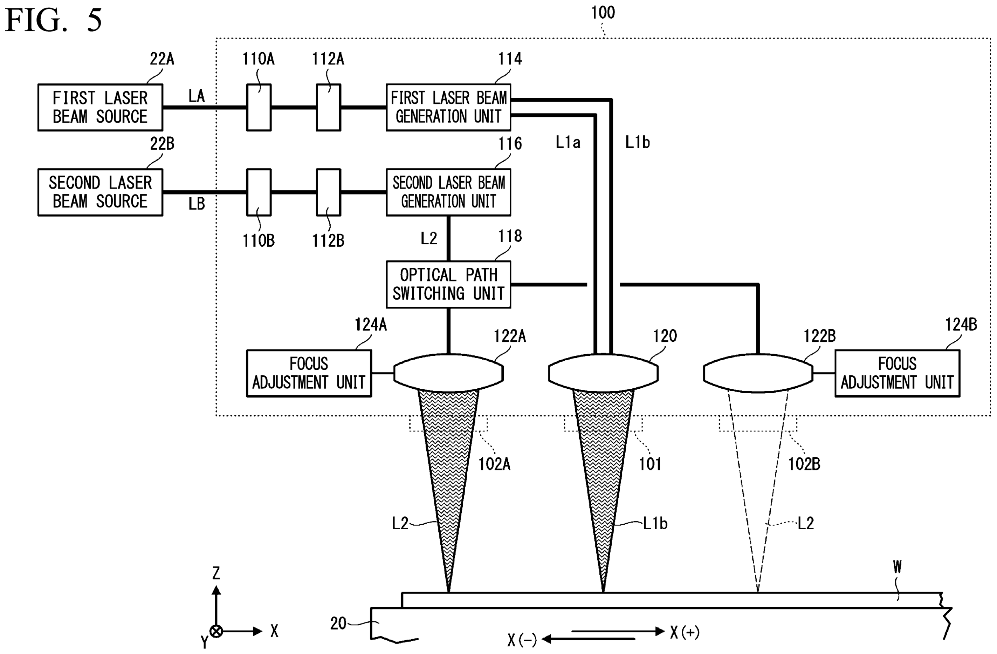

FIG. 5 is a schematic diagram showing an embodiment of the laser machining head.

As shown in FIG. 5, the laser machining head 100 includes a first safety shutter 110A, a second safety shutter 110B, a first high-speed shutter 112A, a second high-speed shutter 112B, a first laser beam generation unit 114, a second laser beam generation unit 116, an optical path switching unit 118, a first condenser lens 120, two second condenser lenses 122A and 122B, two focus adjustment units 124A and 124B, and the like.

The first laser beam generation unit 114 and the first condenser lens 120 constitute a first laser optical system, generate a pair of first laser beams L1a and L1b from the laser beam LA emitted from the first laser beam source 22A, and emit the pair of first laser beams L1a and L1b from the first emission port 101. The second laser beam generation unit 116, the optical path switching unit 118, and the second condenser lenses 122A and 122B constitute a second laser optical system, generate the second laser beam L2 from the laser beam LB emitted from the second laser beam source 22B, and emit the second laser beam L2 from the (2-1)^{th} emission port 102A or the (2-2)^{th} emission port 102B.

The first safety shutter 110A and the first high-speed shutter 112A are arranged on an optical path of the laser beam LA incident on the first laser beam generation unit 114 from the first laser beam source 22A. The first safety shutter 110A and the first high-speed shutter 112A are arranged on the optical path of the laser beam LA in the order of the first safety shutter 110A and the first high-speed shutter 112A from the first laser beam source 22A side. The first safety shutter 110A and the first high-speed shutter 112A separately open and close the optical path under the control of the control device 30. By closing the first safety shutter 110A or the first high-speed shutter 112A, the incidence of the laser beam LA from the first laser beam source 22A is blocked. Thereby, the emission of the first laser beams L1a and L1b is stopped. The first safety shutter 110A functions as a shutter that closes a source of incidence of the first laser beams L1a and L1b. On the other hand, the first high-speed shutter 112A functions as a shutter that temporarily stops the emission of the first laser beams L1a and L1b. For this reason, the first high-speed shutter 112A is configured as a shutter that operates at a higher speed than the first safety shutter 110A.

The first laser beam generation unit 114 generates the pair of first laser beams L1a and L1b for the edge cutting process from the laser beam LA supplied from the first laser beam source 22A. The first laser beam generation unit 114 has, for example, a diffractive optical element (DOE) as a means for generating the pair of first laser beams L1a and L1b. The diffractive optical element is an optical element that can spatially split a laser beam by utilizing a diffraction phenomenon of light. The diffractive optical element can change the laser beam into various patterns and shapes. In the present embodiment, the pair of first laser beams L1a and L1b are generated so that a pair of spots (condensing points or machining points) are formed at a predetermined interval in the Y direction on the wafer W on the table 20 (see FIG. 2). In addition to the above, a refractive optical element (ROE), a Wollaston prism, and the like can also be used as the means for generating the pair of first laser beams L1a and L1b.

The pair of first laser beams L1a and L1b generated by the first laser beam generation unit 114 are radiated onto the wafer W on the table 20 via the first condenser lens 120.

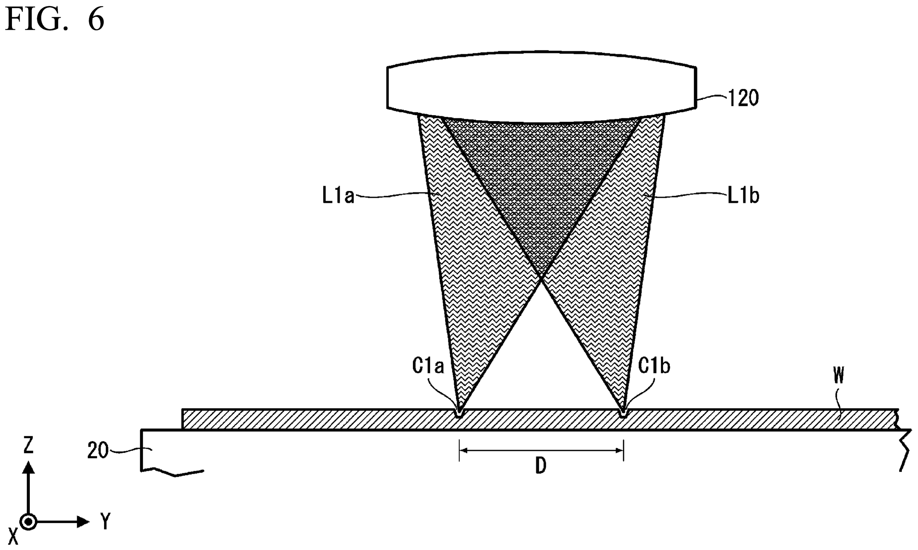

The first condenser lens 120 condenses the pair of first laser beams L1a and L1b generated by the first laser beam generation unit 114 at a predetermined position (focus) in the Z direction and radiates the pair of first laser beams L1a and L1b to the wafer W on the table 20. FIG. 6 is a conceptual diagram of irradiation of the first laser beam from the first condenser lens. The pair of first laser beams L1a and L1b are condensed with a predetermined interval D in the Y direction. This interval D becomes a formation interval of the two edge cutting grooves C1a and C1b.

The second safety shutter 110B and the second high-speed shutter 112B are arranged on the optical path of the laser beam LB incident on the second laser beam generation unit 116 from the second laser beam source 22B. The second safety shutter 110B and the second high-speed shutter 112B are arranged on the optical path of the laser beam LB in the order of the second safety shutter 110B and the second high-speed shutter 112B from the second laser beam source 22B side. The second safety shutter 110B and the second high-speed shutter 112B separately open and close the optical path under the control of the control device 30. By closing the second safety shutter 110B or the second high-speed shutter 112B, the incidence of the laser beam LB from the second laser beam source 22B is blocked. Thereby, the emission of the second laser beam L2 is stopped. The second safety shutter 110B functions as a shutter that closes the source of incidence of the second laser beam L2. On the other hand, the second high-speed shutter 112B functions as a shutter that temporarily stops the emission of the second laser beam L2. For this reason, the second high-speed shutter 112B is configured as a shutter that operates at a higher speed than the second safety shutter 110B.

The second laser beam generation unit 116 generates the second laser beam L2 for the hollowing process from the laser beam LB supplied from the second laser beam source 22B. In the present embodiment, laser beam having a predetermined intensity distribution is generated as the second laser beam L2 for the hollowing process. As an example, a laser beam having a top hat-shaped intensity distribution (also referred to as a flat top) is generated. By making the intensity distribution of the second laser beam L2 in a top hat shape, a bottom surface of the groove to which the hollowing process is applied can be machined flatly. As a means for converting the intensity distribution into a top hat shape, for example, a diffractive optical element (DOE), a refractive beam shaper, or the like can be adopted. An optical element that converts the intensity distribution into a predetermined shape (for example, a top hat shape) in this way is provided in the second laser beam generation unit 116. The second laser beam L2 generated by the second laser beam generation unit 116 is incident on the optical path switching unit 118.

The optical path switching unit 118 switches the optical path of the second laser beam L2 generated by the second laser beam generation unit 116. Specifically, the optical path switching unit 118 alternatively switches the optical path between a first optical path for emitting the second laser beam L2 from the (2-1)^{th} emission port 102A and a second optical path for emitting the second laser beam L2 from the (2-2)^{th} emission port 102B.

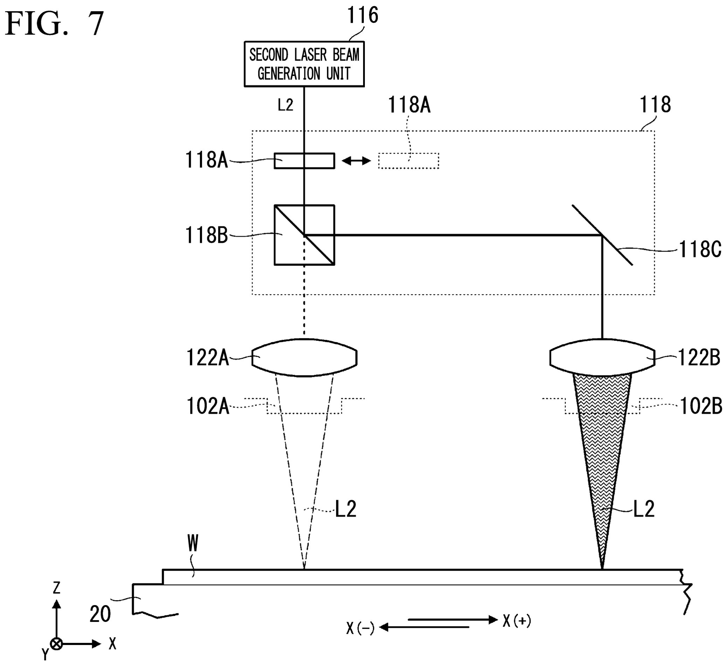

FIG. 7 is a schematic diagram showing an example of a configuration of the optical path switching unit.

As shown in FIG. 7, the optical path switching unit 118 includes a 1/2 wavelength plate (a λ/2 plate) 118A, a polarizing beam splitter (PBS) 118B, a mirror 118C, and the like. In addition, it is assumed that the laser beam LB that is linearly polarized light polarized in a predetermined polarization direction is emitted from the second laser beam source 22B. Therefore, the second laser beam L2 that is linearly polarized light polarized in a predetermined polarization direction is also emitted from the second laser beam generation unit 116.

The 1/2 wavelength plate 118A is inserted into the optical path of the second laser beam L2 emitted from the second laser beam generation unit 116, and rotates the polarization direction of the second laser beam L2 passing therethrough by 90°. The 1/2 wavelength plate 118A is driven by an actuator (not shown), for example, such as a cylinder, and is inserted into and removed from the optical path of the second laser beam L2.

The polarizing beam splitter 118B is arranged on the optical path of the second laser beam L2 emitted from the second laser beam generation unit 116. The polarizing beam splitter 118B splits the incident light into transmitted light and reflected light in accordance with a polarization state of the incident light. In the present embodiment, a setting process is performed so that the second laser beam L2 emitted from the second laser beam generation unit 116 is transmitted when the second laser beam L2 is incident as it is and is reflected when the second laser beam L2 is incident via the 1/2 wavelength plate 118A.

The second laser beam L2 transmitted through the polarizing beam splitter 118B passes through one second condenser lens 122A and is emitted from the (2-1)^{th} emission port 102A.

The second laser beam L2 reflected by the polarizing beam splitter 118B is incident on the other second condenser lens 122B via the mirror 118C and is emitted from the (2-2)^{th} emission port 102B.

In this way, the optical path switching unit 118 of the present embodiment switches the optical path (an emission destination) of the second laser beam L2 by inserting and removing the 1/2 wavelength plate 118A. Although the optical path is switched by inserting and removing the 1/2 wavelength plate 118A in the present embodiment, a similar function can be implemented by rotating the 1/2 wavelength plate 118A by 45°.

The two second condenser lenses 122A and 122B each condense the second laser beam L2 generated by the second laser beam generation unit 116 at a predetermined position (a focus) in the Z direction. Hereinafter, one second condenser lens 122A will be referred to as the (2-1)^{th} condenser lens 122A, and the other second condenser lens 122B will be referred to as the (2-2)^{th} condenser lens 122B, as necessary, to distinguish between the two.

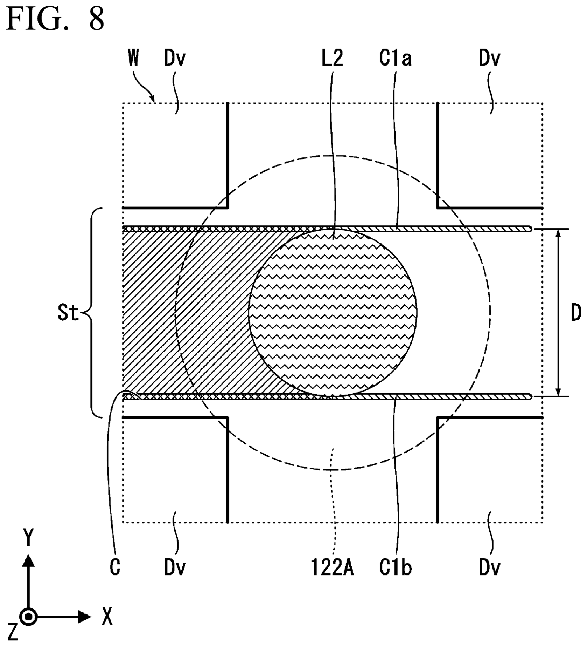

FIG. 8 is a conceptual diagram of the irradiation of the second laser beam from the second condenser lens.

As shown in FIG. 8, the second laser beam L2 is radiated between the two edge cutting grooves C1a and C1b to perform the hollowing process between the two edge cutting grooves C1a and C1b. In the present embodiment, as shown in FIG. 8, a circular spot is formed by the second laser beam L2 to machine an area between the two edge cutting grooves C1a and C1b. The spot is formed with a size (diameter) corresponding to the distance D between the two edge cutting grooves C1a and C1b. In other words, the spot is formed with a size (a diameter) that enables the inside of the two edge cutting grooves C1a and C1b to be cut at once.

The two second condenser lenses 122A and 122B are aligned and arranged in a row along the machining feed direction (the X direction) of the wafer W together with the first condenser lens 120. Moreover, the two second condenser lenses 122A and 122B are arranged to sandwich the first condenser lens 120 therebetween. Specifically, in FIG. 5, the (2-1)^{th} condenser lens 122A, the first condenser lens 120, and the (2-2)^{th} condenser lens 122B are aligned and arranged in a row in this order from left to right in the drawing (the X (+) direction).

The pair of first laser beams L1a and L1b that have passed through the first condenser lens 120 are radiated vertically downward from the first emission port 101 toward the wafer W on the table 20. Moreover, the second laser beam L2 that has passed through the (2-1)^{th} condenser lens 122A is radiated vertically downward from the (2-2)^{th} emission port 102B toward the wafer W on the table 20. Moreover, the second laser beam L2 that has passed through the (2-2)^{th} condenser lens 122B is radiated vertically downward from the (2-2)^{th} emission port 102B toward the wafer W on the table 20.

In the present embodiment, the configuration in which the pair of first laser beams L1a and L1b are radiated onto the wafer W on the table 20 via the first condenser lens 120 to machine the two edge cutting grooves C1a and C1b is an example of a first machining unit. Also, the configuration in which the second laser beam L2 is radiated onto the wafer W on the table 20 via the second condenser lenses 122A and 122B to perform a hollowing process between the two edge cutting grooves C1a and C1b is an example of a second machining unit.

The two focus adjustment units 124A and 124B separately adjust the focal positions of the second laser beams L2 emitted from the two second emission ports 102A and 102B. In the present embodiment, the second condenser lenses 122A and 122B are moved in the Z direction to adjust the focal positions of the second laser beams L2. Hereinafter, as necessary, the focus adjustment unit 124A that adjusts the focal position of the (2-1)^{th} condenser lens 122A will be referred to as the first focus adjustment unit 124A, and the focus adjustment unit 124B that adjusts the focal position of the (2-2)^{th} condenser lens 122B will be referred to as the second focus adjustment unit 124B, to distinguish between the two focus adjustment units 124A and 124B.

The first focus adjustment unit 124A moves the (2-1)^{th} condenser lens 122A in the optical axis direction (the Z direction) to adjust the focal position of the second laser beam L2 emitted from the (2-1)^{th} emission port 102A in the optical axis direction. The second focus adjustment unit 124B moves the (2-2)^{th} condenser lens 122B in the optical axis direction to adjust the focal position of the second laser beam L2 emitted from the (2-2)^{th} emission port 102B in the optical axis direction.

Each of the focus adjustment units 124A and 124B includes a guide mechanism for guiding the second condenser lens 122A or 122B in the Z direction, an actuator for driving the second condenser lens 122A or 122B in the Z direction, a sensor for detecting the position of the second condenser lens 122A or 122B in the Z direction (a position for a reference point), and the like.

By operating the focus adjustment units 124A and 124B, the positions of the second condenser lenses 122A and 122B in the Z direction relatively change with respect to the first condenser lens 120. Thereby, the focal position in the optical axis direction can be changed relatively between the first laser beams L1a and L1b and the second laser beam L2. In other words, the relative positional relationship between the focuses of the first laser beams L1a and L1b and the focus of the second laser beam L2 in the optical axis direction can be adjusted. Thereby, for example, machining is enabled by setting focuses at different positions in the edge cutting process and the hollowing process.

Hereinafter, the focus adjustment unit 124A that adjusts the focal position of the (2-1)^{th} condenser lens 122A will be referred to as a first focus adjustment unit 124A, and the focus adjustment unit 124B that adjusts the focal position of the (2-2)^{th} condenser lens 122B will be referred to as a second focus adjustment unit 124B, as necessary, to distinguish between the two. The focus adjustment units 124A and 124B are examples of the first focus adjustment unit.

### [Function of laser machining device]

### [Groove machining operation]

As described above, the wiring layer removal groove C is machined along the street St with respect to the wafer W having the low-k film, thereby removing the wiring layer including the low-k film from the street St.

The laser machining device 10 processes the wiring layer removal groove C along the street St by moving the table 20 in the machining feed direction while radiating the first laser beams L1a and L1b and the second laser beam L2 from the laser machining head 100 to the wafer W on the table 20. The wiring layer removal groove C is machined at a predetermined width and a predetermined depth.

In the laser machining device 10 of the present embodiment, the emission port of the second laser beam L2 is switched to machine the wiring layer removal groove C in the wafer W on both a forward path and a return path of the machining feed operation.

Specifically, in FIG. 3, a direction in which the table 20 is fed in the X (-) direction is the forward path and a direction in which the table 20 is fed in the X (+) direction is the return path. In the forward path, the second laser beam L2 is emitted from the (2-1)^{th} emission port 102A to machine the wiring layer removal groove C. In the return path, the second laser beam L2 is emitted from the (2-2)^{th} emission port 102B to machine the wiring layer removal groove C. In other words, the second laser beam L2 is always emitted from the emission port positioned on the upstream side of the table 20 in the feed direction, in other words, on the downstream side in the machining progress direction, to machine the wiring layer removal groove C.

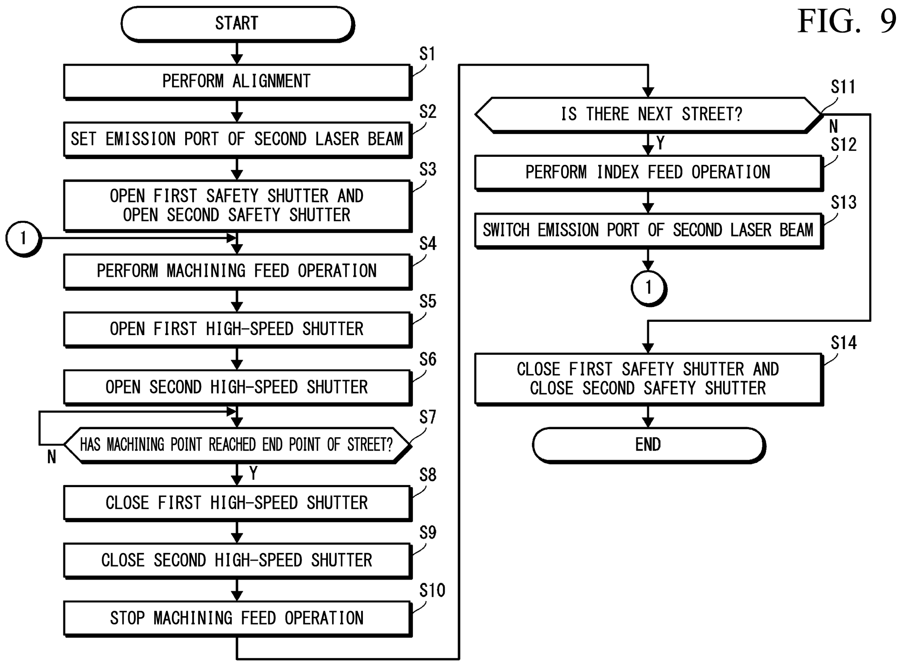

FIG. 9 is a flowchart showing a flow of a machining process of the laser machining device of the present embodiment.

In addition, it is assumed that the wafer W is held on the table 20, and that the laser beams LA and LB is supplied from the first laser beam source 22A and the second laser beam source 22B to the laser machining head 100. Moreover, it is assumed that the first safety shutter 110A, the second safety shutter 110B, the first high-speed shutter 112A, and the second high-speed shutter 112B are closed.

First, alignment is performed (step S1). That is, the machining position is detected and aligned. The alignment is performed on the basis of an image captured by the microscope 50. Through the alignment, the optical axis of the first condenser lens 120 is positioned at a machining start position of the street St.

Subsequently, the emission port of the second laser beam L2 is set (step S2). As described above, in the forward path, the second laser beam L2 is emitted from the (2-1)^{th} emission port 102A to perform the hollowing process. On the other hand, in the return path, the second laser beam L2 is emitted from the (2-2)^{th} emission port 102B to perform the hollowing process. When the second laser beam L2 is emitted from the (2-1)^{th} emission port 102A, the 1/2 wavelength plate 118A is removed from the optical path of the second laser beam L2 in the optical path switching unit 118. On the other hand, when the second laser beam L2 is emitted from the (2-2)^{th} emission port 102B, the 1/2 wavelength plate 118A is inserted into the optical path of the second laser beam L2 in the optical path switching unit 118.

After the emission port of the second laser beam L2 is set, the first safety shutter 110A and the second safety shutter 110B are opened (step S3). Thereby, the laser beams LA and LB are introduced into the laser machining head 100 from the first laser beam source 22A and the second laser beam source 22B. However, because the first high-speed shutter 112A and the second high-speed shutter 112B are closed, the laser beam is not emitted from each emission port.

Subsequently, the machining feed operation is started (step S4). Thereby, the table 10 starts to move in the machining feed direction (the X direction).

Subsequently, the first high-speed shutter 112A is opened (step S5). Thereby, the pair of first laser beams L1a and L1b are radiated toward the wafer W on the table 10. The pair of first laser beams L1a and L1b are emitted from the first emission port 101 via the first condenser lens 120. Thereby, the two edge cutting grooves C1a and C1b are machined along the streets St.

Subsequently, the second high-speed shutter 112B is opened (step S6). Thereby, the second laser beam L2 is radiated toward the wafer W on the table 10. The second laser beam L2 is emitted from the (2-1)^{th} emission port 102A or the (2-2)^{th} emission port 102B. In the forward path, the second laser beam L2 is emitted from the (2-1)^{th} emission port 102A via the (2-1)^{th} condenser lens 122A. On the other hand, in the return path, the second laser beam L2 is emitted from the (2-2)^{th} emission port 102B via the (2-2)^{th} condenser lens 122B. The emitted second laser beam L2 is radiated between the two previously machined edge cutting grooves C1a and C1b. Thereby, the hollowing process is performed between the two edge cutting grooves C1a and C1b. By performing the hollowing process, one wiring layer removal groove C is machined along the street St.

Subsequently, it is determined whether or not a machining point (spot) based on the first laser beams L1a and L1b has reached an end point (a machining end position) of the street St (step S7). The position of the end point of the street St is set separately for each street St.

If the machining point reaches the end point of the street St, the first high-speed shutter 112A is first closed (step S8). Thereby, the edge cutting process is stopped.

Subsequently, the second high-speed shutter 112B is closed (step S9). Thereby, the hollowing process is stopped.

Subsequently, the machining feed operation is stopped (step S10). Thereby, the movement of the table 10 is stopped.

The above steps complete the machining for one street St. Subsequently, it is determined whether or not there is the next street St to be machined (step S11).

When there is the next street St to be machined, the next street St is machined. In this case, first, the table 10 is fed in the Y direction (an index feed operation) toward the position of the next street St to be machined (step S12). The index feed operation is applied to the table 10 by a feed amount corresponding to an interval between the streets St (an interval between the chips). Subsequently, the emission port of the second laser beam L2 is switched (step S13). For example, when the machining feed direction is switched from the forward path to the return path, the emission port is switched to the (2-2)^{th} emission port 102B. On the other hand, when the machining feed direction is switched from the return path to the forward path, the emission port is switched to the (2-1)^{th} emission port 102A. Subsequently, the above-described process from step S4 to step S10 is performed and the wiring layer removal groove C is machined along the street St.

On the other hand, if there is no next street St to be machined, i.e., if machining of all streets St has been completed, the first safety shutter 110A and the second safety shutter 110B are closed (step S14).

Subsequently, the wafer W is collected from the table 20, and the machining for the wafer W is completed.

In this way, the laser machining device 10 of the present embodiment uses the second laser beam L2 to cut the inside of the two edge cutting grooves C1a and C1b machined by the pair of first laser beams L1a and L1b and processes a wiring layer removal groove C of a predetermined width at a predetermined depth along the street St.

### [Focus adjustment]

The laser machining device 10 of the present embodiment has focus adjustment units 124A and 124B, and can relatively adjust the Z-direction positions of the second condenser lenses 122A and 122B with respect to the first condenser lens 120. Therefore, the focus can be set at different positions in the edge cutting process and the hollowing process.

The control device 30 receives the settings of focal positions in the edge cutting process and the hollowing process via the input device 30D and the output device 30E. For example, a focal position setting screen is displayed on the screen of the display constituting the output device 30E, and the input of the settings is received from the input device 30D. In the present embodiment, the settings of the focal positions in the edge cutting process and the hollowing process are received by receiving a designation of an amount of defocus. That is, when machining is performed by adjusting a focus at a specified position, the settings of the focal positions are received by receiving the designation of the amount of defocus. For example, when the edge cutting process is performed with a defocus of N1 [µm] and the hollowing process is performed with a defocus of N2 [µm], the amounts of defocus are designated as N1 [µm] and N2 [µm] and the focal position in each process is set. For example, the defocus is set with the direction away from the table 20 (upward) as a positive (+) direction and the direction close to the table 20 (downward) as a negative (-) direction.

The focus is adjusted by moving the laser machining head 100 in the Z direction with the head drive unit 28 and moving the second condenser lenses 122A and 122B in the Z direction with the focus adjustment units 124A and 124B. Specifically, the overall focus is adjusted by moving the laser machining head 100, and the focus for the hollowing process is adjusted by moving the second condenser lenses 122A and 122B. Therefore, the focus for the edge cutting process is adjusted by moving the laser machining head 100.

For example, when the edge cutting process and the hollowing process are performed with the amount of defocus set to 0 [µm], the positions of the laser machining head 100 and the second condenser lenses 122A and 122B are adjusted so that the focuses are positioned at specified positions. The specified positions are positions where the edge cutting grooves C1a and C1b and the hollowing grooves are machined at a specified width with respect to the wafer W on the table 20. The position of the laser machining head 100 when the focus of the edge cutting process is positioned at the specified position is set as a standard setting position of the laser machining head 100. Moreover, the positions of the second condenser lenses 122A and 122B when the focus of the hollowing process is positioned at the specified position are set as the standard setting positions of the second condenser lenses 122A and 122B. Therefore, when the edge cutting process and the hollowing process are performed with the amount of defocus set to 0 [µm], the laser machining head 100 is positioned at the standard setting position, and the second condenser lenses 122A and 122B are positioned at the standard setting positions.

On the other hand, when the edge cutting process is performed with a defocus of N1 [µm] and the hollowing process is performed with a defocus of N2 [µm], the following settings are made. First, the focus of the edge cutting process is adjusted. The focus of the edge cutting process is adjusted by the laser machining head 100. Specifically, the position of the laser machining head 100 is adjusted so that the focal position is shifted by N1 [µm] from a predetermined position. Subsequently, the focus of the hollowing process is adjusted. The focus of the hollowing process is adjusted by the second condenser lenses 122A and 122B. Specifically, the positions of the second condenser lenses 122A and 122B are adjusted so that the position of the focus is shifted by N2 [µm] from the predetermined position. Here, when the focal position of the edge cutting process is shifted from a reference position, the focal position of the hollowing process is also shifted from the reference position. Therefore, in this case, the difference is calculated as an amount of adjustment and the positions of the second condenser lenses 122A and 122B are adjusted. For example, when the edge cutting process is performed with a defocus of 100 µm and the hollowing process is performed with a defocus of 200 µm, an amount of focus adjustment for the hollowing process is 100 µm.

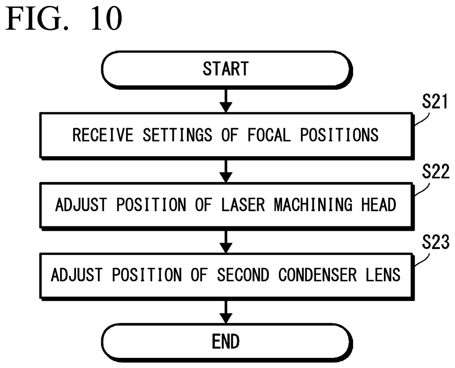

FIG. 10 is a flowchart showing the procedure for the focus adjustment process.

First, a position where the focus is set for each of the edge cutting process and the hollowing process is received (step S21). As described above, the focal position is set by receiving a designation of the amount of defocus.

As an example, in the present embodiment, the default setting is 0 (zero). Therefore, if the amount of defocus is not designated, the amount of defocus is set to 0 and the focuses for the edge cutting process and the hollowing process are set to specified positions.

Subsequently, the position of the laser machining head 100 is adjusted (step S22). When the amount of defocus for the edge cutting process is set to 0, the position of the laser machining head 100 is adjusted so that the focus of the edge cutting process is positioned at a specified position. On the other hand, when the defocus is designated for the edge cutting process, the position of the laser machining head 100 is adjusted so that the amount of defocus becomes a set amount of defocus.

Subsequently, the positions of the second condenser lenses 122A and 122B are adjusted (step S23). When the amount of defocus for the edge cutting process is set to 0 and the amount of defocus for the hollowing process is also set to 0, the positions of the second condenser lenses 122A and 122B are not adjusted. On the other hand, when the defocus is designated for the edge cutting process or the hollowing process, the positions of the second condenser lenses 122A and 122B are adjusted in accordance with the set amount of defocus.

In the above series of steps, the adjustment of the focal position in the edge cutting process and the hollowing process is completed.

In this way, the laser machining device 10 of the present embodiment can separately adjust the focal position for each of the edge cutting process and the hollowing process. Thereby, for example, machining can be performed by setting the focuses at different positions for the edge cutting process and the hollowing process. Thereby, it is possible to adjust the width of the groove to be separately machined for each of the edge cutting process and the hollowing process. That is, because a spot size changes with defocusing, the width of the groove to be machined can be adjusted by adjusting the amount of defocus. In particular, because it is necessary to accurately hollow an area between the two edge cutting grooves C1a and C1b in the hollowing process, a function of enabling the fine adjustment of the spot size is an extremely effective function.

As described above, in the laser machining device 10 of the present embodiment, the laser machining head 100 is moved in the Z direction to adjust the overall focus. In this case, a relative positional relationship is maintained, and the focuses of the edge cutting process and the hollowing process move in the Z direction. Therefore, in the present embodiment, the head drive unit 28 is an example of a second focus adjustment unit.

### [Modification example]

### [Relative focus adjustment]

In the above-described embodiment, the first condenser lens 120 is fixed to the laser machining head 100. However, the first condenser lens 120 may also be configured to be adjustable in the Z direction by providing a focus adjustment unit, like the second condenser lenses 122A and 122B. Alternatively, a configuration in which the second condenser lenses 122A and 122B are fixed to the laser machining head 100 and the first condenser lens 120 is moved in the Z direction by the focus adjustment unit may be adopted. In any configuration, an effect similar to that of the laser machining device 10 of the above-described embodiment can be obtained. In addition, the configuration can be simplified by configuring only one of the first condenser lens 120 and the second condenser lenses 122A and 122B to move in the Z direction.

### [Groove machining]

Although a so-called single-path machining configuration in which one wiring layer removal groove C is machined by a single machining feed operation for one street St is adopted in the above-described embodiment, a so-called multi-path machining configuration in which one wiring layer removal groove C is machined by performing a plurality of machining feed operations for one street St may be adopted. Moreover, in the multi-path machining, only the hollowing process may be divided into a plurality of processes and the plurality of processes are performed. That is, the edge cutting grooves C1a and C1b may be machined by a single machining feed operation, and the hollowing process may be performed by a plurality of machining feed operations.

### [Adjustment of spacing between edge cutting grooves]

Preferably, the spacing between the two edge cutting grooves C1a and C1b to be machined along the street St can be adjusted. The spacing between the edge cutting grooves C1a and C1b can be adjusted by changing the spacing in the Y direction (the spacing in a direction perpendicular to the machining feed direction) between the pair of first laser beams L1a and L1b emitted from the first condenser lens 120. The spacing in the Y direction between the pair of first laser beams L1a and L1b emitted from the first condenser lens 120 can be adjusted, for example, by rotating the emission positions around the optical axis of the first condenser lens 120. Moreover, the emission position can be rotated around the optical axis of the first condenser lens 120, for example, by rotating the diffractive optical element around the optical axis of the laser beam LA in the first laser beam generation unit 114.

### [Hollowing process]

In the above-described embodiment, a single laser beam is emitted from one condenser lens to perform the hollowing process. Specifically, the second laser beams L2 emitted from the second condenser lenses 122A and 122B are switched to perform the hollowing process. The second laser beam L2 emitted at this time is a single laser beam. However, a configuration in which a plurality of laser beams are emitted from one condenser lens to perform the hollowing process may be adopted. In this case, a plurality of second laser beams L2 for performing the hollowing process are aligned and output in the machining feed direction. In other words, a plurality of spots are formed in the machining feed direction. Moreover, in this case, the second laser beam generation unit 116 generates a plurality of second laser beams L2. The plurality of second laser beams L2 can be generated using a diffractive optical element or the like, as in the first laser beam generation unit 114. In this case, the outputs of the plurality of second laser beams L2 may be set to the same value or different values. For example, the output may be set to increase stepwise from the upstream side to the downstream side in the machining progress direction.

Although the shape of the spot is configured to perform the hollowing process with a circular second laser beam in the above-described embodiment, the shape of the spot is not limited thereto when the hollowing process is performed. For example, the shape of the spot may be straight, rectangular, elliptical, or the like so that the hollowing process is performed with a non-circular laser beam.

### [Correction of focal position]

A relative positional relationship of each condenser lens may change due to time-dependent or thermal distortion. In this case, the relative positional relationship of each condenser lens in the Z direction can be corrected by adjusting the positions of the second condenser lenses 122A and 122B.

### [Y-direction position adjustment]

In addition to the adjustment of the focal position in the Z direction, it may also be possible to adjust the focal position in the Y direction. The adjustment of the focal position in the Y direction can be implemented, for example, by adding a mechanism for shifting the second condenser lenses 122A and 122B in the Y direction.

### [Configuration of relative movement between table and laser machining head]

Although the table 20 moves in the X and Y directions and rotates around the θ axis and the laser machining head 100 moves in the Z direction in the above-described embodiment, a relationship of movement between the table 20 and the laser machining head 100 is not limited thereto. It is only necessary to adopt a configuration in which relative movement is performed between the table 20 and the laser machining head 100. For example, the laser machining head 100 may be fixed, and the table 20 may move in three directions, i.e., the X, Y, and Z directions, and rotate around the θ axis. Alternatively, a configuration in which the table 20 moves in the X direction and rotates around the θ axis, and the laser machining head 100 moves in the Y and Z directions may be adopted. Moreover, a configuration in which the table 20 rotates around the θ axis at a fixed position, and the laser machining head 100 moves in three directions, i.e., the X, Y, and Z directions, may be adopted.

### [Others]

Although the example in which the present invention is applied to a device for removing a wiring layer containing a low-k film from streets before dicing a semiconductor wafer using a low-k film as an interlayer insulating film has been described in the above-described embodiment, the application of the present invention is not limited thereto. The present invention can be applied to any device for machining grooves in a wafer by moving a table and a laser machining head relatively in a machining feed direction while radiating a laser beam from the laser machining head onto a wafer on the table.

### REFERENCE SIGNS LIST

10 Laser machining device
20 Table
22A First laser beam source
22B Second laser beam source
24 Microscope
26 Table drive unit
28 Head drive unit
30 Control device
30A Processor
30B Main storage device
30C Auxiliary storage device
30D Input device
30E Output device
100 Laser machining head
101 First emission port
102A Second emission port ((2-1)^{th} emission port)
102B Second emission port ((2-2)^{th} emission port)
110A First safety shutter
110B Second safety shutter
112A First high-speed shutter
112B Second high-speed shutter
114 First laser beam generation unit
116 Second laser beam generation unit
118 Optical path switching unit
118A 1/2 wavelength plate
118B Polarizing beam splitter
118C Mirror
120 First condenser lens
122A Second condenser lens ((2-1)^{th} condenser lens)
122B Second condenser lens ((2-2)^{th} condenser lens)
124A Focus adjustment unit (first focus adjustment unit)
124B Focus adjustment unit (second focus adjustment unit)
C Groove (wiring layer removal groove)
C1a, C1b Groove (edge cutting groove)
L1a, L1b Laser beam (first laser beam)
L2 Laser beam (second laser beam)
LA Laser beam emitted from first laser beam source
LB Laser beam emitted from second laser beam source
W Wafer
Dv Device
St Street

## Claims

1. A laser machining device for machining a workpiece by radiating a laser beam from a laser machining head to the workpiece to which a machining feed operation is relatively applied,
wherein the laser machining head includes
a first machining unit configured to machine two grooves by radiating a pair of laser beams to the workpiece;
a second machining unit configured to machine an area between the two grooves by radiating a second laser beam between the two grooves machined by the first machining unit; and
a first focus adjustment unit configured to adjust a relative positional relationship between a focus of the first laser beam and a focus of the second laser beam in an optical axis direction by relatively moving a focal position of the second laser beam with respect to a focal position of the first laser beam in the optical axis direction.

2. The laser machining device according to claim 1, wherein the laser machining head further includes a second focus adjustment unit configured to adjust focal positions of the first laser beam and the second laser beam in the optical axis direction while maintaining a relative positional relationship between the focus of the first laser beam and the focus of the second laser beam in the optical axis direction.

3. The laser machining device according to claim 1 or 2, wherein the first focus adjustment unit relatively moves a focal position of the second laser beam with respect to a focal position of the first laser beam in the optical axis direction by adjusting a position of a condenser lens in at least one of the first machining unit and the second machining unit in the optical axis direction.

4. The laser machining device according to claim 3, wherein the first focus adjustment unit adjusts a position of the condenser lens in the optical axis direction by moving the condenser lens in the optical axis direction with an actuator.

5. The laser machining device according to claim 1 or 2,
wherein a plurality of second machining units are provided, and
wherein the plurality of second machining units and the first machining unit are arranged in a machining feed direction.

6. The laser machining device according to claim 5, wherein the first machining unit is arranged between the second machining units.

7. The laser machining device according to claim 2, wherein the laser machining head further includes a control unit configured to receive settings of focal positions of the first laser beam and the second laser beam and control the first focus adjustment unit and the second focus adjustment unit so that the focuses of the first laser beam and the second laser beam are positioned at the positions that have been received.

8. The laser machining device according to claim 7, wherein the control unit receives a designation of an amount of defocus and receives the settings of the focal positions of the first laser beam and the second laser beam.
